Europäisches Patentamt

European Patent Office

Office européen des brevets

(19)

(11) Publication number: **0 017 384**
**B1**

(12) **EUROPEAN PATENT SPECIFICATION**

(45) Date of publication of patent specification: **15.02.84**

(21) Application number: **80300835.8**

(22) Date of filing: **19.03.80**

(51) Int. Cl.³: **B 23 K 35/00, H 01 S 3/03, H 01 L 21/60, H 01 L 23/48**

(54) **Process for bonding germanium to metal.**

(30) Priority: **04.04.79 GB 7911817**

(43) Date of publication of application:
**15.10.80 Bulletin 80/21**

(45) Publication of the grant of the patent:
**15.02.84 Bulletin 84/7**

(84) Designated Contracting States:
**CH DE FR NL**

(56) References cited:
**DE - A - 1 527 435**
**DE - A - 2 041 497**
**FR - A - 1 552 571**
**FR - A - 2 027 945**
**FR - A - 2 097 483**
**FR - A - 2 298 883**
**GB - A - 1 482 807**

(73) Proprietor: **Marconi Avionics Limited**
**Marconi House New Street**
**Chelmsford Essex CM1 1PL (GB)**

(72) Inventor: **Evans, Dain Stedman**
**4 Upper Sales, Chaulden Hemel Hempstead**
**Hertfordshire, HP1 2AJ (GB)**

(74) Representative: **Keppler, William Patrick**
**Central Patent Department The General Electric**
**Company Limited Hirst Research Centre East Lane**
**Wembley, Middlesex HA9 7PP (GB)**

Process for bonding germanium to metal.

This invention relates to a process for bonding a germanium component to a metal or alloy surface of a second component, and is also concerned with composite articles and devices which include a component of germanium and a metal- or alloy-surfaced component bonded together by the process described.

The bonding of a germanium component to a component formed of, or having a surface layer composed of, a metal or alloy may be required, for example, in the manufacture of a semiconductor device. In another type of application of germanium, which utilises its property of transparency to infra-red radiation of some wavelengths, it may be employed for forming infra-red transmitting windows in some radiation-emitting or collecting devices. For example, germanium may be used to form a partially reflecting mirror in a laser, for transmitting infrared radiation of desired wavelengths and reflecting radiation of other wavelengths. For such applications, the germanium component is required to be mounted on, and bonded to, a metallic supporting component, which is sealed into an aperture in the main body of the device or may itself constitute the main body of the device: it is usually desirable that the germanium component and its metal support should have substantially matching thermal expansion characteristics in order to minimise stresses generated by differential expansion between these components when they are subjected to changes in temperature in manufacture or use of the device.

It is an object of the present invention to provide a process for forming a vacuum-tight bond capable of withstanding elevated temperatures without rupturing or undergoing any undesirable physical or chemical changes, between a germanium component and a metal or alloy surface of a second component.

It is known from German Offenlegungsschrift No. 2027945 to bond a semi-conductor crystal to a metal surface by a method which comprises coating the metal surface first with a layer of cobalt and then with a layer of gold, and bonding the crystal to the coated metal surface by means of a solder which may consist of tin, or a tin-indium alloy, or an eutectic alloy of gold and silicon.

According to the invention, a process for bonding a first component composed of germanium to a second component of which at least that portion of the surface area to be bonded to the germanium is composed of a metal or alloy, includes the steps of providing a first metal surface which is constituted by, or forms a continuous adherent coating on, the said surface portion of the second component, and which consists of cobalt or nickel, introducing either one or two metallic addition(s) between said first metal surface and that portion of the surface of the germanium component which is to be bonded to the second component, the or each of said metallic addition(s), being of silver or copper, and brazing the components together by heating the assembly of said components, first metal and metallic addition(s), while under light pressure, to a temperature in the range of 650°C to 750°C, which temperature is lower than both the melting points of germanium and of the metal or alloy of which the second component or said surface portion thereof is composed, to cause the formation of a molten braze alloy composition consisting of said first metal and metallic addition(s) and germanium derived from the said first component, and then cooling the assembly to cause the molten braze alloy composition so formed to solidify.

The term "bond surface" of a component will hereinafter be employed to refer to that portion of the surface of the component which is to be bonded to a portion of the surface of the other component.

A metallic addition may be introduced by forming a coating thereof on the said first metal surface, and/or on the bond surface of the germanium component, or may be provided as a separate metal body, suitably in the form of a shim, powder or wire, which is inserted between the first metal surface of the second component and the bond surface of the germanium component. Alternatively, where both silver and copper are employed as metallic additions, the first metal surface may be coated with one of the additions, and the second metallic addition may be introduced either as a coating on the germanium component or as a separate metal body as aforesaid; or both metallic additions may be inserted between the components.

The metals, specified above, which are employed for alloying with the germanium to produce the braze composition are such that the brazing procedure does not result in the formation of any undesirable reaction products, such as intermetallic compounds having characteristics liable to adversely affect the bond.

The said second component may be wholly composed of a metal or alloy; alternatively, the process of the invention may be used for bonding a germanium component to a component of non-metallic, for example ceramic, material at least part of whose surface has been metallised in known manner.

For forming a satisfactory bond which will be free from stress over a wide temperature range, it is usually preferred that the second component has thermal expansion characteristics substantially matching those of germanium. However, in some cases, where the portion of the second component to be bonded to the germanium is a thin member, such as a featheredge portion, of ductile metal, some degree of expansion mismatch may be acceptable.

In some cases, where the said second component, or the bond surface thereof, is composed of nickel or cobalt, a said metallic addition coating may be deposited directly on the bond surface of this component. However, in other cases, where the second component or its bond surface is composed of an alloy or of a metal other than nickel or cobalt, a first metal coating of nickel or cobalt is deposited on the bond surface of the component. Where the second component, or metallised surface thereof, is composed of an alloy, the said first metal coating is preferably a constituent of the alloy. One class of alloys particularly suitable for bonding to germanium, since they have thermal expansion coefficients substantially matching that of germanium, consists of alloys composed mainly of nickel cobalt and iron, such as those identified by the Registered Trade Marks "Nilo K" and "Kovar": the bond surface of a component formed of an alloy of this type is first coated with nickel or cobalt.

Each of the metallic addition specified above forms an eutectic with germanium, which eutectic will alloy with the nickel or cobalt on the second component to form a liquid phase braze composition at a suitable temperature as aforesaid, the eutectic being the predominant constituent of the braze. Thus silver and germanium form an eutectic, containing 19% of germanium, at 651°C, and this eutectic interacts with nickel or cobalt to form a molten braze composition at a slightly lower temperature; similar results are obtained if silver is replaced by copper.

A first metal coating on the bond surface of the second component, in addition to contributing to the braze composition, forms a barrier layer between the underlying metal or alloy structure and the braze, preventing the incorporation of any underlying metal in the braze and thus simplifying the metallurgical constitution of the braze by minimising the number of constituents therein, and in some cases preventing the formation of an alloy having unsuitable properties, for example having an undesirably low melting point. For example, a coating of nickel or cobalt on Nilo K or Kovar prevents the formation of a low melting alloy of the silver-germanium eutectic with iron, nickel and cobalt.

The metal coating and/or inserted metal bodies should be in as pure a form as possible, but it will be understood that the presence in these coatings of small amounts of incidental alloying constituents and impurities, which have no deleterious effect on the bond, is permissible. A coating or coatings on the second component may conveniently be deposited by electroplating. If it is desired to apply a coating of a metallic addition to the germanium component, this can in some cases be done by electroplating, but usually, especially if the germanium is of high purity, other metallising processes such as evaporation or sputtering, or application of the metal as a paint, will give more satisfactory results. If desired, an evaporated or sputtered film may be thickened by subsequent electroplating. The metal coatings or inserts can be of any convenient thickness, but where the first metal is in the form of a coating on the second component the relative thicknesses of this coating and of the metallic addition coating(s) or insert(s) should be such that a part of the first coating remains, between the initial component surface and the braze, after completion of the brazing operation, to form a barrier layer as aforesaid. For example, typical thicknesses may be from 25 to 50 microns for a first metal coating on the second component, and a total of 20 to 40 microns for the additional metal or metals.

The said first metal and metallic addition(s) have low vapour pressures, which is advantageous in view of the elevated temperatures employed for forming the bonds, and the possibility of the bonds being subsequently subjected to high temperatures. These metals are also resistant to atmospheric corrosion; however, the heating procedure for forming the braze is preferably carried out in vacuum. On completion of the heat treatment, the assembly is preferably allowed to cool slowly to room temperature, suitably by retaining it in the furnace while the latter cools, or by appropriate programming.

Some specific process, in accordance with the invention, for bonding a germanium component to a component composed essentially of a nickel-cobalt-iron alloy, which we have carried out, will now be described in the following examples.

### Example 1

For the preparation of a tensile test specimen consisting of a slice of germanium, 10 mm square and 0.5 mm thick, bonded to two strips of Nilo K each 50 mm long, 12 mm wide and 0.7 mm thick, the strips were electroplated, each on an end portion of one face, first with cobalt to a thickness of 50 microns, then with a 15 microns coating of silver, and a coating of silver .12 microns thick was applied to both faces of the germanium slice, also by electroplating. The three components were assembled to form a lapped specimen, with the silver-coated germanium slice sandwiched between the over-lapping coated end portions of the Nilo K strips, and the assembly was heated in a vacuum furnace to a maximum temperature of 680—690°C (that is to say approximately the silver-germanium eutectic temperature) being 20 minutes. The assembly was then allowed to cool slowly to room temperature in the furnace.

### Example 2

A procedure similar to that described in Example 1 was used to prepare a test specimen in which copper was employed instead of silver for coating the germanium slice and the cobalt-plated portions of the Nilo K strips.

### Example 3

A test specimen similar to that deescribed in Example 1 was prepared by a similar procedure, except that the end portions of the Nilo K strips were first plated with nickel instead of cobalt, these portions of the strips, and both faces of the germanium slice, then being plated with silver.

### Example 4

A test specimen of the form described in Example 1 was prepared in the same manner, but using nickel for the first coating on the end portions of the Nilo K strips, and copper for the second coating on the strips and for the coating on both faces of the germanium slice.

A number of specimens were prepared as described in each of the above examples, and the peak temperatures attained during the heating procedures were all in the range of 650°C to 750°C, in each case the assembly being maintained above the silver-germanium or copper-germanium eutectic temperature for 10 to 30 minutes, the longer times being associated with the higher peak temperatures.

The tensile strengths of the composite Nilo K-germanium specimens prepared as described in the above examples were measured at 500°C, and in all cases were found to be in the range of 8 to 11 meganewtons per square metre. This showed that the bond formed between germanium and Nilo K possessed adequate strength to withstand the temperatures of 400—500°C which are typically employed for the vacuum baking of various devices, in the manufacture thereof, for outgassing.

It will be understood that the Nilo K components used in the processes of the examples can be replaced by components of Kovar or any other similar nickel-iron-cobalt or nickel-iron alloy having substantially the same thermal expansion characteristics, or by, for example, ceramic components with bond surfaces metallised with such alloys, with similar results.

One specific form of composite article, which can be formed by bonding together a germanium component and a nickel-cobalt-iron alloy component by any of the methods described in the above examples, is shown in the accompanying diagrammatic drawing, and consists of a germanium window mounted on a metallic support for incorporation in the casing of a gas waveguide laser. In the drawing,

Figure 1 shows the completed composite article in sectional elevation, and

Figure 2 shows, also in sectional elevation, the germanium and metal components before they have been bonded together.

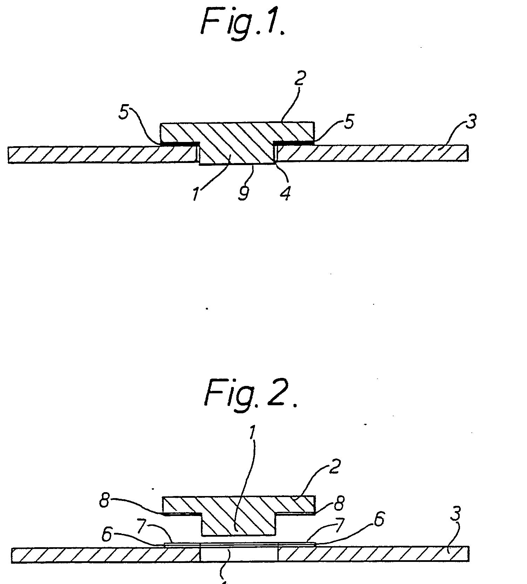

The germanium component is in the form of a cylindrical block 1 with a flange 2, and the metal component is a disc 3 of, for example, Nilo K or Kovar, with a central aperture 4, into which the germanium block 1 is inserted, the flange 2 being bonded to the surface of the disc 3 around the aperture, as shown at 5 in Figure 1.

One method of forming the bond is shown in Figure 2: the edge region of the disc 3 surrounding the aperture is first electroplated with nickel or cobalt, 6, and then with silver or copper 7, and a coating 8, of either the same metal as that of the coating 7 or the alternative metal, is deposited on the mating surface of the flange 2 of the germanium component, by electroplating or by other suitable means. The thickness of the metal coatings are suitably as described above in Example 1. The coated surfaces of the two components are then placed in contact, the components being held together under a small load, and the resulting assembly is heated as described in Example 1 to form the bond 5.

In an alternative method of forming the bond, instead of applying coatings of silver or copper to the nickel- or cobalt-coated portion of the disc 3 and to the flange 2 of the germanium component, silver and/or copper in the form of a shim or shims, powder or wire may be inserted between the mating portions of the components.

In the manufacture of a laser incorporating a germanium window of the form shown in the drawing, the alloy disc 3 is sealed into an aperture in a stainless steel casing (not shown in the drawing), by a known welding technique, in such a position that the surface 9 (Figure 1) of the germanium component is located at one end of the laser waveguide (not shown), the disc 3 thus constituting part of the casing with the flange 2 of the germanium component lying on the exterior thereof. The completed device is finally outgassed by baking at 400°C in vacuum, no deterioration of the germanium-metal bond being detected.

The germanium-metal bonding process of the invention has the additional advantage that, since it is a reactive brazing process, the use of a flux is not usually necessary. Furthermore since the braze alloy composition is of metallurgically simple constitution having only three or four constituents, the brazing process is easy to control in comparison with a system having a larger number of constituent metals.

**Claims**

1. A process for bonding a first component composed of germanium to a second component of which at least that portion of the surface area to be bonded to the germanium is composed of a metal or alloy, which process includes the steps of providing a first metal surface which is constituted by, or forms a continuous adherent coating on, the said surface portion of the second component, and which consists of cobalt or nickel, introducing either one or two metallic addition(s) between said first metal surface and that portion of the surface of the germanium component which is to be bonded to the second component, the or each of said metallic addition(s), being of silver or copper, and brazing the components together by heating the assembly of said components, first metal and metallic addition(s), while under light pressure, to a temperature in the range of 650°C to 750°C, which temperature is lower than both the melting points of germanium and of the metal or alloy of which the second component or said surface portion thereof is composed, to cause the formation of a molten braze alloy composition consisting of the said first metal and metallic addition(s) and germanium derived from the said first component, and then cooling the assembly to cause the molten braze alloy composition so formed to solidify.

2. A process according to Claim 1, characterised in that a coating of said first metal is deposited on the said surface portion of the second component, and in that the thickness of the said first metal coating and the total thickness of the metallic addition(s) are such that only a part of the first metal coating is incorporated in the braze alloy, whereby, after completion of the brazing operation, a sufficient thickness of the first metal coating remains on the second component surface to form a barrier layer between the braze and the underlying metal structure of the second component.

3. A process according to Claim 2, characterised in that the second component is composed of an alloy and in that the said first metal coating is a constituent of the said alloy.

4. A process according to any preceding Claim, characterised in that a said metallic addition is introduced by forming a coating thereof on the said first metal surface portion of the second component, or on the said surface portion of the germanium component, or on the said surface portions of both said components.

5. A process according to any of the preceding Claims 1 to 3, characterised in that a said metallic addition is introduced by inserting a separate body of said addition between the first metal surface portion of the second component and the said surface portion of the germanium component.

6. A process according to Claim 3, for the manufacture of a composite article consisting of a germanium component and a component formed of an alloy consisting mainly of nickel, cobalt and iron and having thermal expansion characteristics substantially matching those of germanium, characterised in that the process includes the steps of electroplating a portion of the surface of the alloy component with nickel or cobalt to form a coating 25 to 50 microns thick, electroplating said coated surface portion with silver or copper to form a coating 10 to 20 microns thick, depositing a coating of silver or copper, 10 to 20 microns thick, on a portion of the surface of the germanium component, holding the coated surfaces of the two components in contact under a small load, heating the assembly so formed in vacuum to a maximum temperature of 680°C to 690°C, the temperature being maintained above 650°C for 20 minutes, and allowing the assembly to cool slowly to room temperature.

**Revendications**

1. Procédé de liaison d'un premier organe formé de germanium à un second organe dont au moins la partie de surface qui doit être liée au germanium est composée d'un métal ou d'un alliage, le procédé étant caractérisé en ce qu'il comprend des opérations de formation d'une première surface métallique qui est constituée par ladite partie de surface du second organe ou qui forme un revêtement continu adhérant à cette partie de surface, et qui est formé de cobalt ou de nickel, d'introduction d'une ou deux additions métalliques entre la première surface métallique et la partie de la surface de l'organe de germanium qui doit être liée au second organe, l'addition métallique ou chaque addition métallique étant formée d'argent ou de cuivre, et de brasage des organes l'une sur l'autre par chauffage de l'ensemble des organes, du premier métal et des additions métalliques, sous une faible pression, à une température comprise entre 650 et 750°C, cette température étant inférieure à la fois aux températures de fusion du germanium ou du métal ou alliage dont le second organe ou sa dite partie de surface est formé, afin qu'une composition fondue d'alliage de brasage, formée du premier métal et des additions métalliques et du germanium tiré du premier organe, soit formée, puis de refroidissement de l'ensemble afin que la composition fondue d'alliage de brasage ainsi formée se solidifie.

2. Procédé selon la revendication 1, caractérisé en ce qu'un revêtement du premier métal est déposé sur ladite partie de surface du second organe, et en ce que l'épaisseur du premier revêtement métallique et l'épaisseur totale des additions métalliques sont telles qu'une partie seulement du premier revêtement métallique est incorporée à l'alliage de brasage si bien que, après la fin de l'opération de brasage, une épaisseur suffisante du premier revêtement métallique reste à la surface du second organe pour qu'elle forme une couche barrière entre la brasure et la structure métallique sous-jacente du second organe.

3. Procédé selon la revendication 2, caractérisé en ce que le second organe est composé d'un alliage et en ce que le premier revêtement métallique est un constituant de l'alliage.

4. Procédé selon l'une quelconque des revendications précédentes, caractérisé en ce qu'une addition métallique est introduite par formation d'un revêtement de celle-ci sur ladite partie de surface du premier métal du second organe ou sur ladite partie de surface de l'organe de germanium ou sur lesdites parties de surface des deux organes.

5. Procédé selon l'une quelconque des revendications 1 à 3, caractérisé en ce que l'addition métallique est introduite par insertion d'un corps séparé de l'addition entre la première partie de surface métallique du second organe et ladite partie de surface de l'organe de germanium.

6. Procédé selon la revendication 3, destiné à la fabrication d'un objet composite formé d'un organe de germanium et d'un organe d'un alliage contenant essentiellement du nickel, du cobalt et du fer et ayant des caractéristiques de dilatation thermique correspondant sensiblement à celles du germanium, caractérisé en ce que le procédé comprend les étape d'électrodéposition de nickel ou de cobalt sur une partie de la surface de l'organe d'alliage afin qu'un revêtement de 25 à 50 microns d'épaisseur soit formé, l'électrodéposition d'argent ou de cuivre sur ladite partie revêtue de surface afin qu'un revêtement de 10 à 20 microns d'épaisseur soit formé, le dépôt d'un revêtement d'argent ou de cuivre, de 10 à 20 microns d'épaisseur, sur une partie de la surface de l'organe de germanium, le maintien en contact, avec une faible charge, des surfaces revêtues des deux organes, le chauffage sous vide de l'ensemble ainsi formé à une température maximale comprise entre 680 et 690°C, la température étant maintenue à plus de 650°C pendant 20 min, et le refroidissement lent de l'ensemble à température ambiante.

## Patentansprüche

1. Verfahren zum Verbinden einer ersten Komponente aus Germanium mit einer zweiten Komponente, von der zumindest derjenige Oberflächenbereich, der mit dem Germanium verbunden werden soll, aus einem Metall oder aus einer Legierung besteht, dadurch gekennzeichnet, daß eine erste Metallfläche hergestellt wird, die den Oberflächenbereich der zweiten Komponente umfaßt oder aus einem auf dem Oberflächenbereich kontinuierlich anhaftenden Überzug gebildet ist und aus Kobalt oder Nickel besteht, daß ein oder zwei Metallzusätze zwischen der ersten Metallfläche und demjenigen Bereich der Oberfläche der Germaniumkomponente eingefügt werden, die mit der zweiten Komponent verbunden werden soll, wobei der oder die Metallzusätze Silber oder Kupfer sind, daß die Bestandteile durch Erhitzen der Anordnung aus den Komponenten der ersten Metallfläche und den Metallzusätzen auf eine Temperatur im Bereich von 650°C bis 750°C unter leichtem Druck hart zusammengelötet werden, daß die Temperature niedriger als die Schmelztemperaturen von Germanium und dem Metall oder der Legierung ist, aus dem bzw. der die zweite Komponente oder der Oberflächenbereich zusammengesetzt ist, um die Ausbildung einer geschmolzenen Lotzusammensetzung aus dem Metall der ersten Metallfläche, den Metallzusätzen und dem Germanium der ersten Komponente zu erhalten, und daß die Anordnung abgekühlt wird, um die geschmolzene Lotzusammensetzung zu verfestigen.

2. Verfahren zum Verbinden einer ersten Komponente aus Germanium mit einer zweiten Komponente, von der zumindest derjenige Oberflächenbereich, der mit dem Germanium verbunden werden soll, aus einem Metall oder aus einer Legierung besteht, nach Anspruch 1, dadurch gekennzeichnet, daß ein Überzug, der die erste Metallfläche bildet, auf dem Oberflächenbereich der zweiten Komponente angeordnet wird, und daß die Dicke des Überzugs und die Gesamtdicke der Metallzusätze so gewählt wird, daß nur ein Teil des Überzugs in die Lotlegierung miteinbezogen wird, wodurch nach Beendigung des Lötvorgangs der Überzug in ausreichender Stärke auf der Oberfläche der zweiten Komponente vorhanden ist, um eine Sperrschicht zwischen dem Lot und der darunterliegenden Metallstruktur der zweiten Komponente zu bilden.

3. Verfahren zum Verbinden einer ersten Komponente aus Germanium mit einer zweiten Komponente, von der zumindest derjenige Oberflächenbereich, der mit dem Germanium verbunden werden soll, aus einem Metall oder aus einer Legierung besteht, nach Anspruch 2, dadurch gekennzeichnet, daß die zweite Komponente aus einer Legierung besteht, und daß der Überzug, der die erste Metallfläche bildet, ein Bestandteil dieser Legierung ist.

4. Verfahren zum Verbinden einer ersten Komponente aus Germanium mit einer zweiten Komponente, von der zumindest derjenige Oberflächenbereich, der mit dem Germanium verbunden werden soll, aus einem Metall oder aus einer Legierung besteht, nach den Ansprüchen 1 bis 3, dadurch gekennzeichnet, daß einer der Metallzusätze hinzugefügt wird, indem ein Überzug davon auf dem Oberflächenbereich der zweiten Komponente, der Germaniumkomponente, oder auf den Oberflächenbereichen beider Komponenten gebildet wird.

5. Verfahren zum Verbinden einer ersten Komponente aus Germanium mit einer zweiten Komponente, von der zumindest derjenige Oberflächenbereich, der mit dem Germanium verbunden werden soll, aus einem Metall oder aus einer Legierung besteht, nach den Ansprüchen 1 bis 3, dadurch gekennzeichnet, daß einer der Metallzusätze durch das Einschieben eines eigenen Körpers des Zusatzes zwischen dem Oberflächenbereich der zweiten Komponente und dem Oberflächenbereich der Germaniumkomponente eingefügt wird.

6. Verfahren zum Verbinden einer ersten Komponente aus Germanium mit einer zweiten Komponente, von der zumindest derjenige Oberflächenbereich, der mit dem Germanium verbunden werden soll, aus einem Metall oder aus einer Legierung besteht, nach Anspruch 3, zur Herstellung eines zusammengesetzten Gegenstandes aus einer Germaniumkomponente und einer Legierungskomponente, hauptsächlich aus Nickel, Kobalt und Eisen bestehend, mit Wärmeausdehnungseigenschaften, die denjenigen des Germaniums angepaßt sind, dadurch gekennzeichnet, daß ein Bereich der Oberfläche der Legierungskomponente mit Nickel oder Kobalt elektroplattiert wird, um einen Überzug von 25 bis 50 μm Dicke zu formen, daß der so überzogene Oberflächenbereich mit Kupfer oder Silber elektroplattiert wird, um einen Überzug von 10 bis 20 μm Stärke zu bilden, daß ein Überzug von 10 bis 20 μm Dicke Silber oder Kupfer auf einem Oberflächenbereich der Germaniumkomponente niedergeschlagen wird, daß die überzogenen Oberflächenbereiche der beiden Komponenten unter geringem Druck miteinander in Berührung gebracht werden, daß diese Anordnung unter Vakuum auf eine maximale Temperatur von 680°C bis 690°C erhitzt, eine Temperatur über 650°C zwanzig Minuten aufrechterhalten wird, und daß die Anordnung langsam auf Raumtemperatur abgekühlt wird.

**0 017 384**

# Fig.1.

# Fig.2.

1